(19) Europäisches Patentamt
European Patent Office
Office européen des brevets

(11) **EP 3 393 087 B1**

(12) **EUROPEAN PATENT SPECIFICATION**

(45) Date of publication and mention
of the grant of the patent:
**25.11.2020 Bulletin 2020/48**

(51) Int Cl.:
**H04L 12/28** *(2006.01)*          **H04L 12/64** *(2006.01)*
**H03H 7/00** *(2006.01)*

(21) Application number: **17167364.3**

(22) Date of filing: **20.04.2017**

(54) **ETHERNET OVER COAXIAL HYBRID ADAPTER PROVIDING AN AC/DC POWER SUPPLY PATH AND A DVB-S/S2 PATH ON THE SAME COAXIAL CABLE**

ETHERNET ÜBER KOAXIALEN HYBRIDADAPTER ZUR BEREITSTELLUNG EINES WECHSELSTROM-GLEICHSTROM-STROMVERSORGUNGSPFADES UND DVB-S/S2-PFAD AUF DEMSELBEN KOAXIALKABEL

ADAPTATEUR HYBRIDE ETHERNET SUR CÂBLE COAXIAL FOURNISSANT UN TRAJET D'ALIMENTATION ÉLECTRIQUE CA/CC ET UN TRAJET DVB-S/S2 SUR LE MÊME CÂBLE COAXIAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**24.10.2018 Bulletin 2018/43**

(73) Proprietor: **Eutelsat S.A.**
**75015 Paris (FR)**

(72) Inventors:
• **Bonaventura, Marco**
**30174 Venezia (VE) (IT)**
• **Martin, Massimo**
**3500 Galzignano Terme (PD) (IT)**

(74) Representative: **Cabinet Camus Lebkiri**
**25 rue de Maubeuge**
**75009 Paris (FR)**

(56) References cited:
**EP-A2- 1 675 288          CN-U- 204 258 828**
**CN-Y- 200 976 595**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### FIELD OF THE INVENTION

The present invention concerns the field of the passive Ethernet over coaxial adapters. According to an aspect of the invention, the adapter of the invention is a hybrid passive coupler compliant with the 10Base-T or 100Base-TX Ethernet physical layer. According to another aspect of the invention, the adapter according to the invention is adapted to further provide an AC/DC power supply path along with a DVB-S/S2 path on a same coaxial cable.

### PRIOR ART

Despite the proliferation of local area network (LAN) based on the 10Base-T or 100Base-Tx standard (10/100 Base T), coaxial cables installations are still common in home wiring. For example, coaxial cables are widely used to bring broadband data into homes as television cables.

The coexistence of these two technologies continuously calls for new technical solutions, especially regarding the coupling of Ethernet and coaxial cables. Typical applications for such a coupling are Internet access or broadband data broadcast through coaxial cables.

Moreover, some applications require the transmission of an Ethernet signal on a coaxial cable along with other signals like a DVB-S/S2 signal. An example of such an application is the technology developed by Eutelsat® and disclosed in the international patent application WO 2013/087502 A1 "Transmission/Reception of microwave signals broadcast by a satellite with an interactive return channel using a spectral broadening protocol".

Several technical problems have to be solved in coupling an Ethernet signal to a coaxial cable.

First of all, a 10/100 Base T Ethernet cable uses two pairs of twisted cables for transmission/reception Tx/Rx while a coaxial cable is a unique conductive wire surrounded by an insulator and a conductive shield. Besides, the impedances of the Ethernet cable and of the coaxial cable are different and they need to be matched in order to make the data transfer possible. In order to make this connection, special circuits called hybrid transceiver or simply hybrid can be used.

The hybrid circuit acts as a splitter, separating the transmitted signal from the received signal. Nevertheless, hybrids can be very ineffective in removing the transmitted signal from the receiving channel. As a consequence, the received signal can be heavily disturbed by the transmitted one.

Most of the proposed hybrid architectures are active circuits with an echo cancellation stage. Examples of coupling circuits with an active stage for echo cancelling are given in the document US 2015/0334186. However, these solutions require active modulation/demodulation steps which greatly increases the cost of the device.

Other examples are given in CN 200 976 595 Y, CN 204 258 828 U, EP 1 675 288 A2.

The current state of the art lacks of affordable solutions to provide power supply, DVB - S/S2 signal and Ethernet data through a coaxial cable. This kind of solution is highly demanded for installations providing internet access through satellite connections, pay-per-view television, personal subscription management and other broadcasting services.

### SUMMARY OF THE INVENTION

The present invention aims to address the above mentioned drawbacks by proposing a passive Ethernet over coaxial adapter which is simple to realize, inexpensive and ready to plug.

Moreover, the Ethernet over coaxial adapter of the present invention can be connected directly to the Ethernet Physical transceiver and it is compliant with all the PHY Ethernet transceivers available on the market.

To this purpose, as disclosed by the attached independent claim, the object of the present invention is an Ethernet over coaxial adapter for coupling an Ethernet transceiver to a coaxial cable, said device comprising at least:

- a transmitting port adapted to the 10Base-T or to the 100Base-TX standard;
- a receiving port adapted to the 10Base-T or to the 100Base-TX standard;
- a coaxial port adapted to be connected to a coaxial cable;
- a first set of passive components;
- a second set of passive components;

wherein:

- the first set of passive components is connected to the transmitting port, the coaxial port and the second set of passive elements;
- the first set of passive components comprises at least a first transformer and an impedance matching network having a load impedance, the first transformer connecting the signal from the transmitting port to both the coaxial port and the impedance matching network, the load impedance matching the coaxial cable impedance in order to minimize the coupling between the transmission port and the receiving port and to maximize the coupling between the coaxial port and the transmission port;
- the second set of passive components is connected to at least the coaxial port through the first set of passive elements and to the receiving port, the second set of passive components comprising at least a second transformer adapted to match the impedance of the receiving port and the impedance of the coaxial cable connected to the coaxial port in order to maximize the coupling between the receiving port and the coaxial port;

- the transmitting port is connected to the primary coil of the first transformer, the secondary coil of the first transformer comprises a central tap splitting the secondary coil of the first transformer in an upper and a lower secondary coil, the central tap is connected to the second set of passive elements, the lower secondary coil is connected to an impedance matching network and the upper secondary coil is connected to the coaxial port

In the 10/100 Base-T standard each port is connected through a double twisted pair. The transmitting port and the receiving port are directly connected to an Ethernet physical transceiver.

Alternatively, the transmitting port and the receiving port can be connected to one extremity of a 10/100 Base-T Ethernet cable. For example, an Rj45 connector can be used as a connector for the Ethernet cable.

The transmitting and the receiving ports have a 100 Ohm differential impedance in the 10Base-T and 100Base-TX standards.

The coaxial port is connected to the coaxial cable. For example, an F-type connector can be used for the coaxial port. The coaxial port has a 75 Ohm impedance.

When implementing an Ethernet coaxial connection, two main problems have to be solved:

- Avoiding the echo between the receiving and the transmitting paths, for example when a signal is transmitted from the transmitting Ethernet path to the coaxial line, part of this signal can be coupled in the receiving Ethernet path causing a parasite received signal;
- Matching the impedance of the Ethernet cable and the impedance of the coaxial cable in order to optimize the reception and/or the transmission of the signal.

The present invention uses two sets of passive elements placed in between the transmitting/receiving port of the Ethernet cable and the coaxial line to solve these two problems.

We mean by a first set of passive components an ensemble of passive elements as transformers, resistors, capacitors and inductors. For example, the first set of passive elements S1 comprises at least a first transformer T1. The transmitting port is connected to the primary coil PL1 of the first transformer T1. The secondary coil comprises a central tap splitting the secondary coil in an upper USL1 and a lower secondary coil LSL1. The central tap CT is connected to the second set S2 of passive elements. The lower secondary coil LSL1 is connected to a load network or impedance matching network and the upper secondary coil ULS1 is connected to the coaxial port P2.

A part of these elements forms an impedance matching network having a load impedance matching the impedance of the coaxial cable.

Advantageously, when the load network in the first set of passive elements S1 matches the impedance of the coaxial cable, an effective echo cancellation takes place, avoiding the coupling of the transmitted signal to the receiving port P3.

We mean by a second set of passive components S2 an ensemble of passive elements as transformers, resistors, capacitors and inductors. The second set of passive element comprises at least a second transformer T2, whose primary coil is connected to the receiving path. The secondary coil of the second transformer is connected to the central tap of the first transformer.

Advantageously, thanks to the second transformer T2, it is possible to match the impedance between the receiving port and the coaxial port in order to maximize the transmission of a signal from the coaxial cable to the receiving port.

Advantageously, the use of the two sets of passive elements connected to the transmitting port, the receiving port and the coaxial port makes it possible to cancel the interferences between transmitted and received signals and to maximize the coupling between the Ethernet physical layer and the coaxial cable.

Besides the main features mentioned above, the Ethernet over coaxial adapter according to the present invention may include one or more additional characteristics from those listed in the following, either individually or in any technical possible combination thereof:

- the primary coil of the second transformer is connected to the receiving port and the secondary coil of the second transformer is connected to the central tap of the first transformer ;
- the receiving port comprises a resistive termination;
- the Ethernet over coaxial adapter comprises a fully differential amplifier amplifying the signal issued from the second transformer and directed to the receiving port;
- the Ethernet over coaxial adapter comprises a first capacitor connected in parallel to the transmitting port and a second capacitor connected in parallel to the receiving port, the first and second capacitor acting as low-pass filters for the transmitting and the receiving ports;
- the Ethernet over coaxial adapter comprises a decoupling capacitor connected to the coaxial port and the first set of passive elements;
- the transmission port and the receiving port are integrated in a Rj45 connector and the coaxial port is a F-connector.
- the impedance matching network is adapted to the characteristics of the coaxial cable;

- the primary coils of the two transformers comprise a first and a second central tap, at least one of said first and second central tap being connected to the digital supply of the Ethernet transceiver.

Another object of the invention is a circuit providing an AC/DC power supply path comprising :

- the Ethernet over coaxial (EoC) adapter according to the invention;
- a Bias Tee block for the transmission of the DC components;
- supply In and/or supply Out connectors.

The circuit providing an AC/DC power supply path can further provide a DVB-S/S2 path on the coaxial cable and comprises a diplexer circuit for multiplexing the Ethernet and the Dvb-S/S2 signal on the coaxial cable.

**LIST OF FIGURES**

Other characteristics and advantages of the invention will be evident from the description that is provided in the following, purely for a non-limiting, exemplary purposes, with reference to the accompanying drawings in which:

- Figure 1 is a scheme of the Ethernet over coaxial adapter according to the invention;
- Figure 2 represents a circuit implementing the Ethernet over coaxial adapter of figure 1;
- Figure 3a represents the cross-port attenuation of the device of figure 2 as a function of the frequency;
- Figure 3b represents the port matching characteristic of the device in figure 2;
- Figure 4 shows the single transformer architecture on which the adapter of figure 2 relies;
- Figure 5 represents a detailed scheme of an implementation of the adapter of figure 1;
- Figure 6 shows an advanced version of the circuit of figure 2 in which a termination variation or resistive termination has been added to the receiving path;
- Figure 7 shows an advanced version of the circuit of figure 2 in which an active amplifier has been added;
- Figure 8 shows a block diagram of a circuit comprising the Ethernet over coaxial adapter according to the previous figures and in which a further AC/DC supplying path has been added;
- Figure 9 shows a first example of the circuit according to figure 8;
- Figure 10 shows a second example of the circuit according to figure 9;
- Figure 11 shows a block diagram of the circuit of figure 8-10 further comprising a DVB - S/S2 path.
- Figure 12 shows a circuit used to multiplex the Ethernet signal and the DVB-S/S2 signal and comprised in the circuit of figure 11.

**DETAILED DECRIPTION OF THE INVENTION**

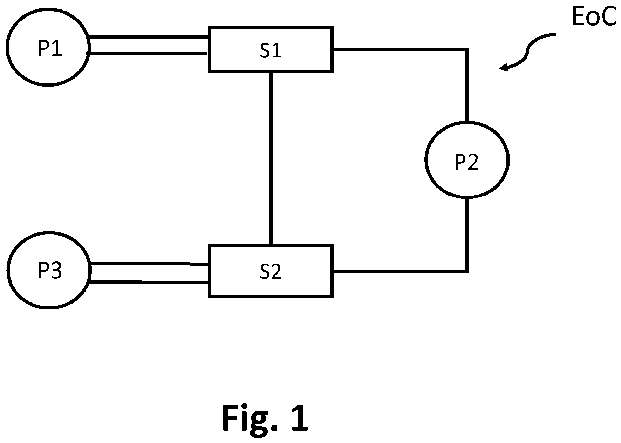

Figure 1 shows a schematic representation of Ethernet over Coaxial adapter EoC. This device will be called indifferently EoC adapter, Eoc hybrid or simply hybrid in the following.
The EoC adapter comprises:

- a transmitting 100Base-TX port P1; the port P1 is a 100 Ohm differential port;
- a receiving 100Base-TX port P3; the port P3 is a 100 Ohm differential port;
- a coaxial port P2; the port P2 is a 75 Ohm, single ended port;
- the first set of passive elements S1, the set of passive elements S1 being connected to the transmitting port P1, the coaxial port P2 and the second set of passive elements S2;
- the second set of passive elements S2, connected to the first set of passive elements S1 and to the receiving port P3.

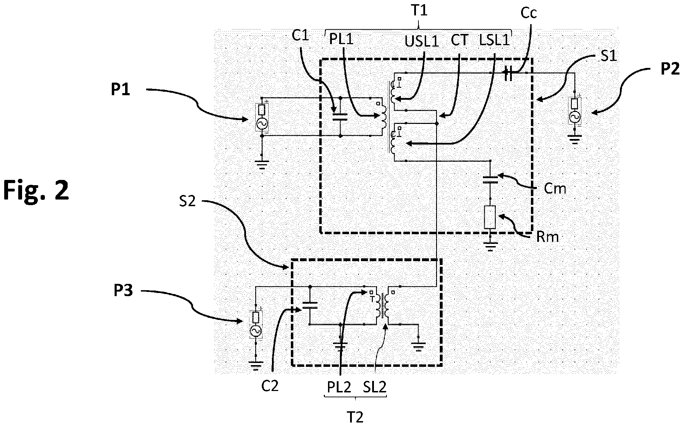

Figure 2 shows a specific embodiment of the device of figure 1.
According to this embodiment the first set of passive elements S1 comprises:

- a first transformer T1 comprising a primary coil PL1 and a secondary coil splitted by a central tap CT in an upper secondary coil USL1 and a lower secondary coil LSL1;
- a load network or matching impedance network comprising a matching capacitance Cm and a matching resistance Rm;
- a capacitance C1;
- a capacitance Cc.

An extremity of the upper secondary coil USL1 is connected in series to the capacitance Cc and to the coaxial port P2.
An extremity of the lower secondary coil LSL1 is connected in series to the load network or matching impedance network comprising the matching capacitance Cm and the matching resistance Rm. The load network is further connected to the ground.
According to this embodiment, the second set of passive elements S2 comprises:

- a second transformer T2 comprising a primary coil PL2 and a secondary coil SL2;
- a capacitance C2.

The capacitance C1 and the capacitance C2 act as a first order low-pass filter and eliminate the high frequency harmonics of the respectively transmitted and received Ethernet signal.
The central tap point CT splitting the secondary coil of the first transformer T1 is connected to an extremity of the secondary coil SL2 of the second transformer T2. The other extremity of the secondary coil SL2 of the second transformer is grounded.

The ground reference potential of the coaxial port P2 can be the same as the transceiver P1, P2 and the second transformer T2 reference potential.

Alternatively, the coaxial ground is the same as the load network and the same as the secondary coil SL2 of T2 but it is different from the ground potential of the transmitting P1 and the receiving P3 port. This feature is normally referred as an electric isolation between electronic device - P1 and P3 ports - and the coaxial port P2.

The transmission 100Base-TX port P1 is coupled to the top transformer T1. The transmitted signal is then equally split in two branches at the central tap point CT of the secondary coil of the first transformer T1. A first branch is the lower secondary coil LSL1 connected in series with the impedance matching network and the second branch is the upper secondary coil USL1 of the first transformer T1 connected in series with the coaxial port P2, having a coaxial load.

If the two branches are equivalent, i.e. the two branches have the same impedance, the central tap CT of the first transformer is virtually at ground with respect to the signal transmitted by P1 and no signal leaks into the receiver port P3.

Advantageously, the attenuation between port P1 and port P3 is maximized which avoids interferences between the transmitting and the receiving path of the Ethernet cable.

According to the embodiment of figure 2, the components of the load network are Cm is comprised in the range between 100nF and 390nF and Rm is comprised in the range between 70 and 80 Ohm in order to match the impedance of the coaxial cable, nominally equal to 75Ohm. Other values and impedance networks are possible.

Advantageously the coupling between the transmitting port P1 and the coaxial port P2 is then maximized and the echo is cancelled.

When a signal source exists on the coaxial port P2, part of the signal is coupled with the bottom transformer and the signal is adapted to the receiver impedance.

Advantageously, the double transformer scheme of figure 2 minimizes the attenuation between the coaxial port P2, the transmission port P1 and the reception port P2. In other words, the transmission of the signal from the Ethernet cable to the coaxial cable and vice-versa is optimal.

Moreover, the transmitting port P1 and the receiving port P3 are perfectly interchangeable. In other words, the performances of the adapter according to figure 2 are exactly the same if P1 and P3 are exchanged.

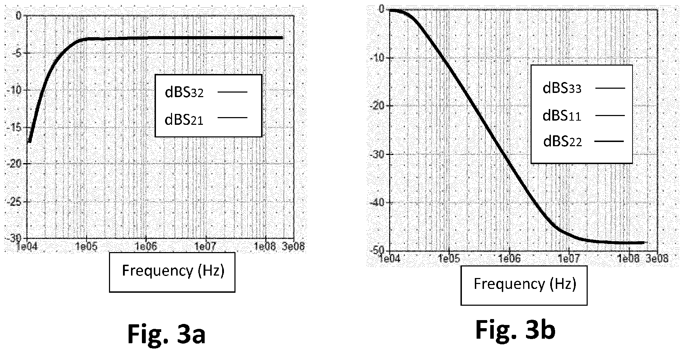

Figure 3a shows the cross port coupling as a function of the frequency. The curve $dBS_{32}$ represents the ratio between the power of the signal plugged on the receiving port P3 and the power of the signal emitted by the coaxial port P2 and shows an excellent coupling between these two ports. The same is true for the curve $dBS_{21}$ which is perfectly superposed to $dBS_{32}$.

The curve $dBS_{31}$ represents the coupling between port 3 and port 1 and is lower than -35dB, which means an excellent attenuation between these two ports. This curve is out of the scale of figure 3a.

The graphs of figure 3a show then that the Ethernet Phy layer and the coaxial cable are well coupled, while the echo between the receiving and the transmitting path of the Ethernet Phy layer is cancelled.

Figure 3b shows the port matching for ports P1, P2 and P3 expressed in decibel (dB). The graphs represent the ratio between the signal reflected by a given port and the signal coupled to the same port. The ratio is very low in the range of frequency of interest. This means that the input signals are very efficiently coupled in the Eoc hybrid.

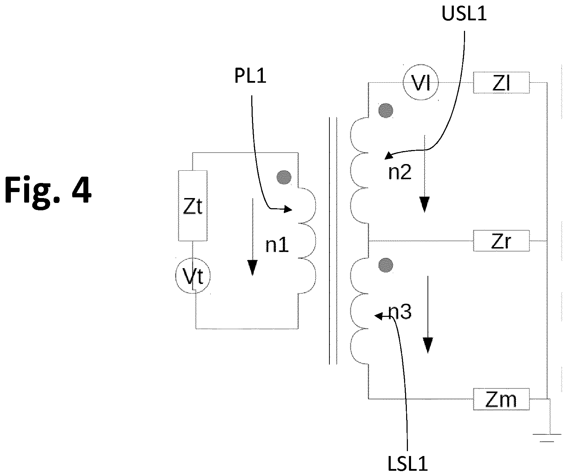

The principle of the invention is explained based on figure 4 which shows the first transformer T1.

Zt is the transmission impedance, Zl is the coaxial line impedance, Zr is the receiver impedance and Zm is the matching network impedance.

I1 is the current in the primary coil PL1 of the first transformer T1 having n1 windings and V1 is the voltage across PL1. The central tap CT splits the secondary coil in the upper secondary coil USL1 having n2 windings and the lower secondary coil LSL2 having n3 windings.

If the transformer is ideal the following equations hold:

$$\frac{V_1}{n1} = \frac{V_2}{n2} = \frac{V_3}{n3}$$

And

$$I_1 n_1 + I_2 n_2 + I_3 n_3 = 0$$

In order to determine the echo cancellation conditions, we set the voltage across the receiving path Vr=0, while enabling the transmission of a signal by Vt. This implies Ir=0 and I2=I3. This is equivalent to V2/Zl = V3/Zm or n2/Zl = n3/Zm, which can be rewritten as Zm/n3=Zl/n2.

If the secondary coil is symmetric n2=n3 and we have Zl=Zm. The echo cancellation is perfect if the matching impedance is equal to the coaxial cable impedance.

Moreover, it can be shown that if impedances are matched the maximum power transfer between the transmitting port P1 and the coaxial port P2 is obtained when Zr = Zl/2.

This equation is not automatically satisfied because the Ethernet transceiver has a Zr= 100Ohm differential impedance when the coaxial line impedance is 75 Ohm. So Zr should be Zl/2, nominally 37.5 Ohm. In order to solve this drawback, the present invention uses the second transformer T2 to match impedances.

For example, the winding ratio of the second transformer T2 can be chosen in order to adapt Zr. For example by choosing

$$\sqrt{2\,Zr/Zl} = \sqrt{100/37.5} = 1.63.$$

Advantageously the second transformer is used to match the impedance of the Ethernet cable and of the coaxial cable. The power of the signal transmitted between the two cables is then maximized.

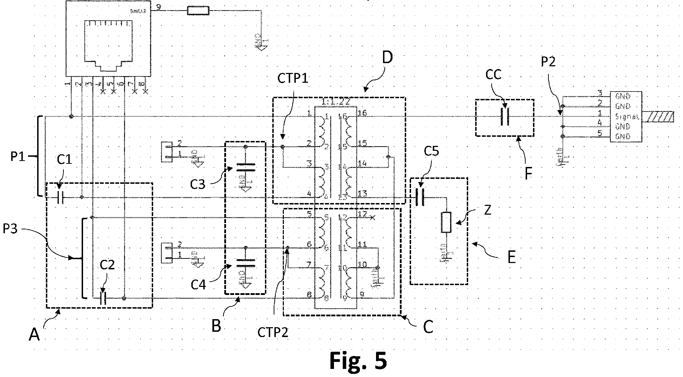

Figure 5 shows a detailed implementation of the Eoc hybrid according to the invention.

The blocks D and C of figure 5 represent respectively the first transformer T1 and the second transformer T2.

The block E is the matching impedance network. In the example showed in figure 5 this impedance matching network comprises a capacitor C5 in series with an impedance Z. The capacitor C5 can also be omitted.

For example, Z can comprise two resistors R1 and R2 connected in parallel.

Alternatively, Z can be a simple resistor or a parallel formed by an inductor and a resistor, R//L.

Advantageously, the structure of the impedance matching network and its load impedance can be adapted to coaxial line impedance. The coaxial line impedance can change for example based on the coaxial cable length for example if the other termination of the coaxial cable is not exactly equal to 75 Ohm.

The transmitting port P1 and the receiving port P3 are directly connected to the Ethernet transceiver.

Alternatively, the transmitting port P1 and the receiving port P3 are connected to an Rj45 connector for plugging an Ethernet cable.

The coaxial port P3 is connected to an F-connector for plugging a coaxial cable.

In this embodiment, the primary coils of the two transformers comprise a central tap CTP1, CTP2. The purpose of these central taps CTP1 and CTP2 is to be compliant with most of the Ethernet Phys. In fact, some of them require the central tap of the magnetic to be connected to the digital supply, accordingly to the 100Base-TX application notes of the specific transceiver. This is true because we want to remove specific Ethernet magnetic using only the EoC hybrid magnetics.

The capacitors C3 and C4 are bypass capacitors used to obtain a stable supply.

Advantageously, it is possible to connect the Eoc hybrid according to this embodiment directly to the Ethernet Physical transceiver.

The block A of figure 5 comprises two capacitors C1 and C2 acting as low-pass filters in the transmitting and in the receiving paths.

Advantageously, these capacitors remove high frequency Ethernet harmonics. For this purpose, C1 and C2 should be in the range of some pF, for example 10 pF in the example of figure 5.

The block F comprises an AC/DC decoupling circuit. In the example of figure 5 this block is a capacitor Cc = 150 nF.

This block is needed because the input impedance at the coaxial port P2 at DC without Cc would be a short circuit for any DC component available on the line. Such circuit is designed considering that the equivalent input impedance is an inductor in parallel with a resistor. According to the values of components in blocks C and D a capacitor of a few hundred nF should be used.

It is worth to note that the EoC hybrid according to the present invention works properly even if the real components, like the coaxial cable, have a mismatch between the nominal values of impedance and their real values. In particular, the Eoc hybrid according to the present invention offers optimal performances with an impedance mismatch as high as 5 Ohm.

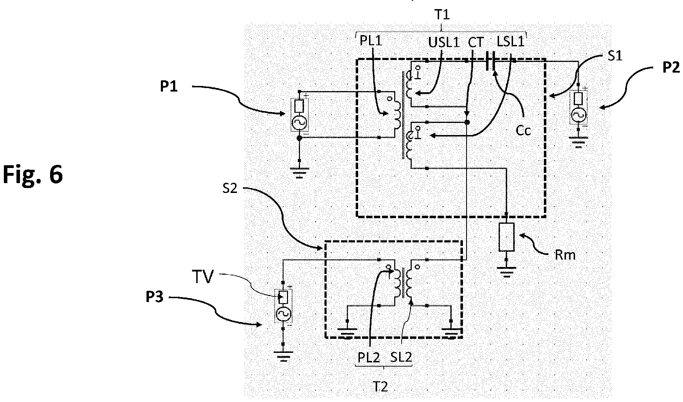

Figure 6 shows an advanced version of the circuit of figure 2 in which a termination variation TV has been added to the receiving path. The termination variation is a resistive termination.

The Eoc hybrid of figure 2 has the drawback that 3.0 dB losses are included in the transmitting path and in the receiving path. As a consequence, the total nominal hybrid attenuation of 6.0 dB excluding parasitic loss.

To solve this issue, the circuit of figure 6 uses the second transformer T2 to provide a +3dB voltage gain in order to compensate the 3dB loss in the transmission channel P1. In this embodiment, a receiving path termination of 300 Ohm is used.

Advantageously, this termination variation TV allows for a more robust communication link. For example, with such a scheme it is possible to use longer cables.

It is worth to note that some of the 100Base-TX Physical transceiver integrate the receiving path termination in the chip. In these cases, the solution of figure 6 is not applicable.

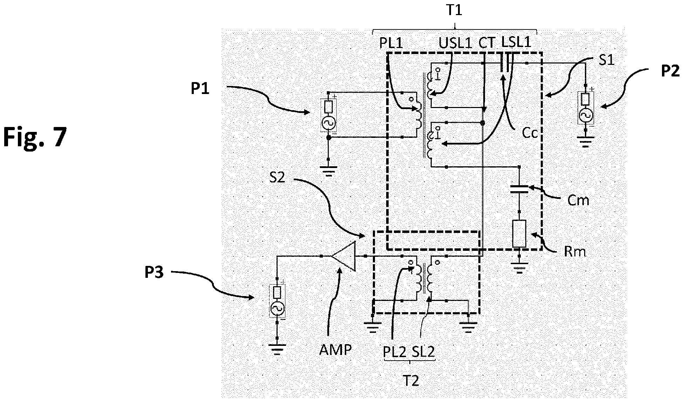

In such a case the circuit of figure 7 can be used. In this case the gain in the receiving path is obtained through a fully differential amplifier AMP.

Advantageously the scheme of figure 7 is compatible with any 100Base-TX Ethernet Physical layer.

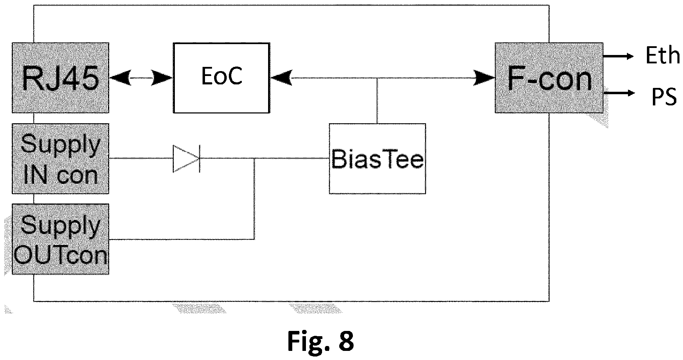

According to an embodiment of the Eoc Hybrid according to the invention, it is possible to add an AC/DC power supply on the coaxial line as it is showed in the circuit of figure 8.

For example, the AC power supply can support 24V AC for specific market where it is available. The AC power supply need to be low frequency i.e. 50 or 60Hz.

In the block diagram of figure 8 the RJ45 block represents the connector providing the Ethernet signal through the transmitting path associated to the port P1 and the receiving path associated to the port P3. The Eoc hybrid can be realized according to one of the scheme according to the invention and previously presented.

The Supply In and Supply Out are the connector providing the power supply. According an embodiment, only the Supply In or only the Supply Out connection is provided. According to another embodiment, both Supply in and Supply out are provided.

The Bias Tee block provides the DC component to the coaxial line.

A Bias Tee circuit is a standard three ports circuit used for setting the AC/DC bias point of a circuit. The Bias Tee can be properly designed to not affect the transmission of the AC components.

Alternatively, the circuit of figure 8 can be connected directly to the Ethernet Physical transceiver without using an RJ45 connector.

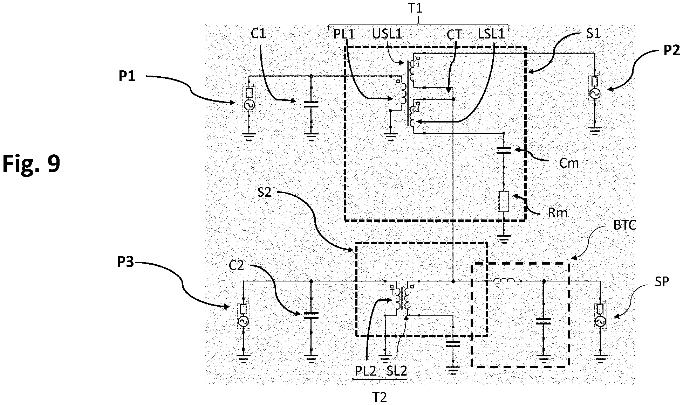

The circuit of figure 8 can be implemented for example by using the detailed scheme of figure 9.

The circuit of figure 9 has its first transformer T1 connected through the central tap CT to the Bias Tee circuit BTC and the AC/DC supply port SP. Any signal present on the central tap CT is not coupled with the Ethernet receiving path.

Advantageously, the circuit of figure 9 eliminates the coupling between the Power Supply noise and the Ethernet receiving path.

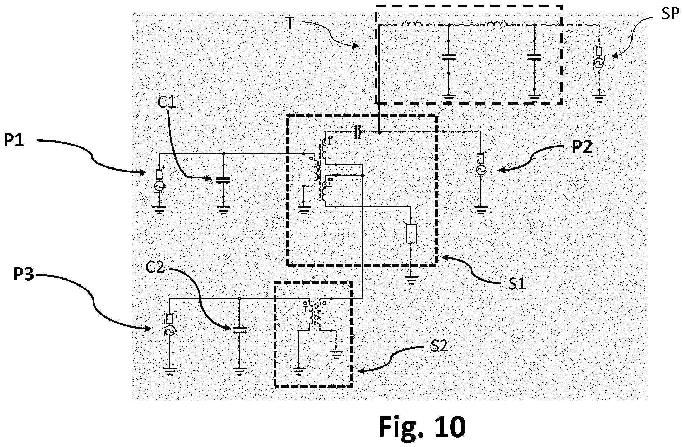

According to another embodiment of the present invention, the block diagram of figure 8 can be implemented with the circuit represented in figure 10.

In this case the Bias Tee circuit is a filter used to insert the AC/DC power supply. In the example of figure 10 the filter is a third order T filter connected to the AC/DC supply port.

Advantageously, the circuit of figure 10 is completely compatible with the Eoc hybrid described in figure 2.

According to an embodiment of the present invention it is possible to add a DVB-S/S2 path on the coaxial line. This embodiment of the present invention can be used for example in the SmartLNB system developed by Eutelsat and described in the international patent application WO 2013/087502 A1 "Transmission/Reception of microwave signals broadcast by a satellite with an interactive return channel using a spectral broadening protocol".

In a SmartLNB system a DVB-S/S2 signal can be delivered from the outdoor unit to the indoor unit. This signal can coexist together with the 100Base-TX signal as they use different band. In fact, the 100Base-TX signal uses the band comprised between 100kHz and 125 MHz while the DVB-S/S2 signal uses the band comprised between 925 Mhz and 2175MHz.

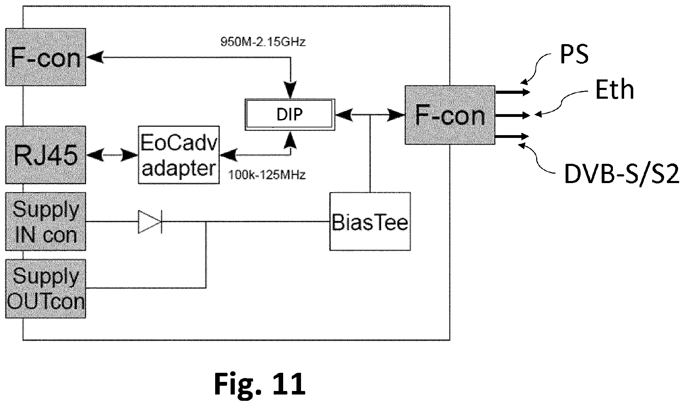

Figure 11 shows a block diagram for a circuit comprising an Eoc Adapter, an AC/DC power supply path SP and a DVB-S/S2 signal path over the coaxial line. The Ethernet signal Eth and the DVB-S/S2 signal are multiplexed using a diplexer DIP. Multiplexing the two signals means, for example, that the two signals are transmitted along the same path.

Alternatively, the circuit of figure 11 can be connected directly to the Ethernet Physical transceiver without using an RJ45 connector.

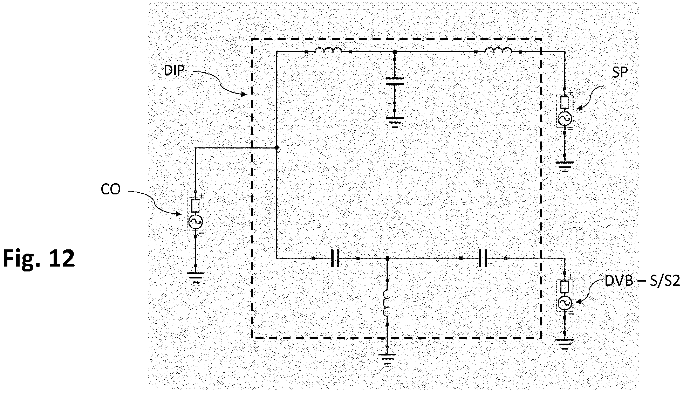

Figure 12 shows the diplexer circuit used in the block diagram of figure 11 according to an embodiment of the present invention. In this case the diplexer is a third order diplexer.

It is worth to note that all the technical features that have been described in reference to the 100Base-TX standard can be used also with the 10Base-T standard.

**Claims**

1. An Ethernet over coaxial adapter (Eoc) for coupling an Ethernet transceiver to a coaxial cable, said adapter comprising at least:

   - a transmitting port (P1) adapted to the 10Base-T or to the 100Base-TX standard;
   - a receiving port (P3) adapted to the 10Base-T or to the 100Base-TX standard;
   - a coaxial port (P2) adapted to be connected to a coaxial cable;
   - a first set of passive components (S1);
   - a second set of passive components (S2);

   wherein:

   - the first set of passive components (S1) is connected to the transmitting port (P1), the coaxial port (P2) and the second set of passive elements (S2);
   - the first set of passive components (S1) comprises at least a first transformer (T1) and an impedance matching network (Cm, Rm) having a load impedance, the first transformer (T1) connecting the signal from the transmitting port (P1) to both the coaxial port (P2) and the impedance matching network (Cm, Rm), the load impedance matching the coaxial cable impedance in order to minimize the coupling between the transmission port (P1) and the receiving port (P3) and to maximize the coupling between the coaxial port (P2) and the transmission port (P1);
   - the second set of passive components (S2) is connected to at least the coaxial port (P2) through the first set of passive components (S1) and to the receiving port (P3), the second set of passive components (S2) comprising at least a second transformer (T2) adapted to match the impedance of the receiving port (P3) and the impedance of the coaxial cable connected to the coaxial port (P2) in order to maximize the coupling between the receiving port (P3) and the coaxial port (P2);
   - the transmitting port (P1) is connected to the primary coil (PL1) of the first transformer (T1), the secondary coil of the first transformer (T1) comprises a central tap (CT) splitting the secondary coil of the first transformer in an upper (USL1) and a lower secondary coil (LSL1), the central tap (CT) is connected to the second set of passive elements (S2), the lower secondary coil (LSL1) is connected to the impedance matching network (Cm, Rm) and the upper secondary coil (USL1) is connected to the coaxial port (P2).

2. The Ethernet over coaxial adapter (EoC) according to claim 1 **characterized in that** the primary coil (PL2) of the second transformer (T2) is connected to the receiving port (P3) and the secondary coil (SL2) of the second transformer (T2) is connected to the central tap (CT) of the first transformer (T1).

3. The Ethernet over coaxial adapter (EoC) according to one of the previous claims **characterized in that** the receiving port (P3) comprises a resistive termination (TV).

4. The Ethernet over coaxial adapter (EoC) according to one of the previous claims **characterized in that** it comprises a fully differential amplifier (AMP) amplifying the signal issued from the second transformer (T2) and directed to the receiving port (P3).

5. The Ethernet over coaxial (EoC) adapter according to one of the previous claims **characterized in that** it comprises a first capacitor (C1) connected in parallel to the transmitting port (P1) and a second capacitor (C2) connected in parallel to the receiving port (P3), the first (C1) and second capacitor (C2) acting as low-pass filters for the transmitting and the receiving ports.

6. The Ethernet over coaxial (EoC) adapter according to one of the previous claims **characterized in that** it comprises a de-coupling capacitor (Cc) connected to the coaxial port (P2) and the first set of passive elements (S1).

7. The Ethernet over coaxial (EoC) adapter according to one of the previous claims **characterized in that** the transmission port (P1) and the receiving port (P2) are integrated in a Rj45 connector and the coaxial port is a F-connector.

8. The Ethernet over coaxial (EoC) adapter according to one of the previous claims **characterized in that** the impedance matching network is adapted to the characteristics of the coaxial cable.

9. The Ethernet over coaxial (Eoc) adapter according to one of the previous claims **characterized in that** the primary coils of the first (T1) and second transformer (T2) comprise a first and a second central tap (CTP1, CTP2), at least one of said first and second central tap being connected to the digital supply of the Ethernet transceiver.

10. A circuit providing an AC/DC power supply path comprising:

    - the Ethernet over coaxial (EoC) adapter according to one of the previous claims;
    - a Bias Tee block for the transmission of the DC components;
    - supply In and/or supply Out connectors.

11. The circuit according to the previous claim further providing a DVB-S/S2 path on the coaxial cable and comprising a diplexer (DIP) circuit for multiplexing the Ethernet and the Dvb-S/S2 signal on the coaxial cable.

**Patentansprüche**

1. Ethernet-über-koaxialem Adapter (Eoc) zum Koppeln eines Ethernet-Sendeempfängers an ein koaxiales Kabel, wobei der genannte Adapter wenigstens umfasst:

    - einen Übertragungsport (P1), der an den 10Base-T oder an den 100Base-TX-Standard angepasst ist;
    - einen Empfängerport (P3), der an den 10Base-T oder den 100Base-TX-Standard angepasst ist;
    - einen koaxialen Port (P2), der angepasst ist, um an ein koaxiales Kabel angeschlossen zu sein;
    - einen ersten Satz passiver Bauteile (S1);
    - einen zweiten Satz passiver Bauteile (S2);

    wobei:

    - der erste Satz passiver Bauteile (S1) an den Übertragungsport (P1), den koaxialen Port (P2) und den zweiten Satz passiver Elemente (S2) angeschlossen ist;
    - der erste Satz passiver Bauteile (S1) wenigstens einen ersten Transformator (T1) und ein Impedanzabstimmungs-Netzwerk (Cm, Rm) mit einer Lastimpedanz umfasst, wobei der erste Transformator (T1) das Signal von dem Übertragungsport (P1) sowohl an den koaxialen Port (P2) als auch das Impedanzabstimmungs-Netzwerk (Cm, Rm) anschließt, wobei die Lastimpedanz die koaxiale Kabelimpedanz abstimmt, um die Kopplung zwischen dem Übertragungsport (P1) und dem Empfängerport (P3) zu minimieren und die Kopplung zwischen dem koaxialen Port (P2) und dem Übertragungsport (P1) zu maximieren;

- der zweite Satz passiver Bauteile (S2) an wenigstens den koaxialen Port (P2) durch den ersten Satz passiver Bauteile (S1) und an den Empfangsport (P3) angeschlossen ist, wobei der zweite Satz passiver Bauteile (S2) wenigstens einen zweiten Transformator (T2) umfasst, der zum Abstimmen der Impedanz des Empfangsports (P3) und der Impedanz des koaxialen Kabels abgestimmt ist, das an den koaxialen Port (P2) angeschlossen ist, um die Kopplung zwischen dem Empfangsport (P3) und dem koaxialen Port (P2) zu maximieren;

- der Übertragungsport (P1) an die primäre Spule (PL1) des ersten Transformators (T1) angeschlossen ist, die sekundäre Spule des ersten Transformators (T1) eine zentrale Verzweigung (CT) umfasst, die die sekundäre Spule des ersten Transformators in eine obere (USL1) und eine untere sekundäre Spule (LSL1) aufteilt, die zentrale Verzweigung (CT) an den genannten zweiten Satz passiver Elemente (S2) angeschlossen ist, die untere sekundäre Spule (LSL1) an das Impedanzabstimmungs-Netzwerk (Cm, Rm) angeschlossen ist und die obere sekundäre Spule (USL1) an den koaxialen Port (P2) angeschlossen ist.

2. Ethernet-über-koaxialem Adapter (Eoc) gemäß Anspruch 1, **dadurch gekennzeichnet, dass** die primäre Spule (PL2) des zweiten Transformators (T2) an den Empfangsport (P3) angeschlossen ist und die sekundäre Spule (SL2) des zweiten Transformators (T2) an die zentrale Verzweigung (CT) des ersten Transformators (T1) angeschlossen ist.

3. Ethernet-über-koaxialem Adapter (Eoc) gemäß einem der voranstehenden Ansprüche, **dadurch gekennzeichnet, dass** der Empfangsport (P3) ein ohmscher Abschluss (TV) ist.

4. Ethernet-über-koaxialem Adapter (Eoc) gemäß einem der voranstehenden Ansprüche, **dadurch gekennzeichnet, dass** er einen vollständig differentialen Verstärker (AMP) umfasst, der das Signal verstärkt, das von dem zweiten Transformator (T2) ausgegeben ist und zu dem Empfangsport (P3) gerichtet ist.

5. Ethernet-über-koaxialem Adapter (Eoc) gemäß einem der voranstehenden Ansprüche, **dadurch gekennzeichnet, dass** es einen ersten Kondensator (C1), der parallel zu dem Übertragungsport (P1) angeschlossen ist, und einen zweiten Kondensator (C2), der parallel zu dem Empfangsport (P3) angeschlossen ist, umfasst, wobei der erste (C1) und der zweite (C2) Kondensator als Tiefpassfilter für die Übertragungs- und die Empfangsports fungieren.

6. Ethernet-über-koaxialem Adapter (Eoc) gemäß einem der voranstehenden Ansprüche, **dadurch gekennzeichnet, dass** er einen Entkopplungs-Kondensator (Cc) umfasst, der an den koaxialen Port (P2) und den ersten Satz passiver Elemente (S1) angeschlossen ist.

7. Ethernet-über-koaxialem Adapter (Eoc) gemäß einem der voranstehenden Ansprüche, **dadurch gekennzeichnet, dass** der Übertragungsport (P1) und der Empfangsport (P2) in einen Rj45-Anschluss eingebaut sind und der koaxiale Port ein F-Anschluss ist.

8. Ethernet-über-koaxialem Adapter (Eoc) gemäß einem der voranstehenden Ansprüche, **dadurch gekennzeichnet, dass** das Impedanzabstimmungs-Netzwerk an die Merkmale des koaxialen Kabels angepasst ist.

9. Ethernet-über-koaxialem Adapter (Eoc) gemäß einem der voranstehenden Ansprüche, **dadurch gekennzeichnet, dass** die primären Spulen des ersten (T1) und des zweiten Transformators (T2) eine erste und eine zweite zentrale Verzweigung (CTP1, CTP2) umfassen, wobei wenigstens eine der genannten ersten und zweiten zentralen Verzweigung an die digitale Versorgung des Ethernet-Sendeempfängers angeschlossen ist.

10. Schaltung, die einen Wechselstrom-/Gleichstrom-Leistungsversorgungspfad bereitstellt, umfassend:

- den Ethernet-über-koaxialem Adapter (Eoc) gemäß einem der voranstehenden Ansprüche;
- einen Vorspannungs-T-Block für die Übertragung der Gleichstrom-Bauteile
- Bereitstellung von Eingangs- und / oder Bereitstellung von AusgangsAnschlüssen.

11. Schaltung gemäß dem voranstehenden Anspruch, die weiterhin einen DVB-S/S2-Pfad auf dem koaxialen Kabel bereitstellt und eine Diplexer-Schaltung (DIP-Schaltung) zum Multiplexen des Ethernets und des Dvb-S/S2-Signals auf dem koaxialen Kabel umfasst.

**Revendications**

1. Adaptateur Ethernet sur câble coaxial (Eoc) pour coupler un émetteur-récepteur Ethernet à un câble coaxial, ledit adaptateur comprenant au moins :

- un port d'émission (P1) adapté à la norme 10Base-T ou 100Base-Tx ;

- un port de réception (P3) adapté à la norme 10Base-T ou 100Base-Tx ;
- un port coaxial (P2) adapté pour être connecté à un câble coaxial ;
- un premier ensemble de composants passifs (S1) ;
- un second ensemble de composants passifs (S2) ;

dans lequel :

- le premier ensemble de composants passifs (S1) est connecté au port d'émission (P1), au port coaxial (P2) et au second ensemble d'éléments passifs (S2) ;
- le premier ensemble de composants passifs (S1) comprend au moins un premier transformateur (T1) et un réseau d'adaptation d'impédance (Cm, Rm) ayant une impédance de charge, le premier transformateur (T1) connectant le signal depuis le port d'émission (P1) à la fois au port coaxial (P2) et au réseau d'adaptation d'impédance (Cm, Rm), l'impédance de charge s'associant à l'impédance du câble coaxial afin de minimiser le couplage entre le port d'émission (P1) et le port de réception (P3) et pour maximiser le couplage entre le port coaxial (P2) et le port d'émission (P1) ;
- le second ensemble de composants passifs (S2) est connecté au moins au port coaxial (P2) par le biais du premier ensemble de composants passifs (S1) et au port de réception (P3), le second ensemble de composants passifs (S2) comprenant au moins un second transformateur (T2) adapté pour égaler l'impédance du port de réception (P3) et l'impédance du câble coaxial connecté au port coaxial (P2) afin de maximiser le couplage entre le port de réception (P3) et le port coaxial (P2) ;
- le port d'émission (P1) est connecté à la bobine primaire (PL1) du premier transformateur (T1), la bobine secondaire du premier transformateur (T1) comprend une dérivation centrale (CT) divisant la bobine secondaire du premier transformateur en une bobine secondaire supérieure (USL1) et en une bobine secondaire inférieure (LSL1), la dérivation centrale (CT) est connectée au second ensemble d'éléments passifs (S2), la bobine secondaire inférieure (LSL1) est connectée au réseau d'adaptation d'impédance (Cm, Rm) et la bobine secondaire supérieure (USL1) est connectée au port coaxial (P2).

2. Adaptateur Ethernet sur câble coaxial (Eoc) selon la revendication 1 **caractérisé en ce que** la bobine primaire (PL2) du second transformateur (T2) est connectée au port de réception (P3) et la bobine secondaire (SL2) du second transformateur (T2) est connectée à la dérivation centrale (CT) du premier transformateur (T1).

3. Adaptateur Ethernet sur câble coaxial (Eoc) selon l'une des revendications précédentes **caractérisé en ce que** le port de réception (P3) comprend une terminaison résistive (TV).

4. Adaptateur Ethernet sur câble coaxial (Eoc) selon l'une des revendications précédentes **caractérisé en ce qu'**il comprend un amplificateur entièrement différentiel (AMP) amplifiant le signal émis depuis le second transformateur (T2) et dirigé vers le port de réception (P3).

5. Adaptateur Ethernet sur câble coaxial (Eoc) selon l'une des revendications précédentes **caractérisé en ce qu'**il comprend un premier condensateur (C1) connecté en parallèle au port d'émission (P1) et un second condensateur (C2) connecté en parallèle au port de réception (P3), les premier (C1) et second (C2) condensateurs servant de filtres passe-bas pour les ports d'émission et de réception.

6. Adaptateur Ethernet sur câble coaxial (Eoc) selon l'une des revendications précédentes **caractérisé en ce qu'**il comprend un condensateur de découplage (Cc) connecté au port coaxial (P2) et au premier ensemble d'éléments passifs (S1).

7. Adaptateur Ethernet sur câble coaxial (Eoc) selon l'une des revendications précédentes **caractérisé en ce que** le port d'émission (P1) et le port de réception (P2) sont intégrés dans un connecteur Rj45 et le port coaxial est un connecteur F.

8. Adaptateur Ethernet sur câble coaxial (Eoc) selon l'une des revendications précédentes **caractérisé en ce que** le réseau d'adaptation d'impédance est adapté aux caractéristiques du câble coaxial.

9. Adaptateur Ethernet sur câble coaxial (Eoc) selon l'une des revendications précédentes **caractérisé en ce que** les bobines primaires des premier (T1) et second (T2) transformateurs comprennent une première et une seconde dérivation centrale (CTP1, CTP2), au moins l'une desdites première et seconde dérivations centrales étant connectée à l'alimentation numérique de l'émetteur-récepteur Ethernet.

10. Circuit fournissant un trajet d'alimentation électrique CA/CC comprenant :

- l'adaptateur Ethernet sur câble coaxial (EoC) selon l'une des revendications précédentes ;
- un bloc té de polarisation pour la transmission des composants CC ;
- des connections d'alimentation d'entrée et/ou d'alimentation de sortie.

11. Circuit selon la revendication précédente fournissant en outre une voie DVB-S/S2 sur le câble coaxial et comprenant un circuit diplexeur (DIP) pour le multiplexage de l'Ethernet et du signal Dvb-S/S2 sur le câble coaxial.

**Fig. 1**

Fig. 2

Fig. 3a

Fig. 3b

**Fig. 4**

**Fig. 5**

**Fig. 6**

**Fig. 7**

**Fig. 8**

Fig. 9

**Fig. 10**

Fig. 11

**Fig. 12**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013087502 A1
- US 20150334186 A
- CN 200976595 Y
- CN 204258828 U
- EP 1675288 A2